# DEMANDE DE BREVET EUROPEEN

(11) **EP 4 746 641 A1**
(43) Date de publication de la demande: **20.05.2026**
(21) Numéro de dépôt: 25214718.6
(22) Date de dépôt: 10.11.2025
(51) Int. Cl.: H10F 71/00, H10F 77/70, H10F 10/19, H10P 74/20

(54) **PROCÉDÉ DE POLISSAGE CHIMIQUE DE PLAQUES DE SILICIUM**

(30) Priorité: 19.11.2024 FR 2412618
(71) Demandeur: Commissariat à l'Energie Atomique et aux Energies Alternatives, 75015 Paris (FR)
(72) Inventeur: LIGNIER, Hélène, 38054 GRENOBLE CEDEX 09 (FR); SALLABERRY, Ludovic, 38054 GRENOBLE CEDEX 09 (FR); VALLA, Anthony, 38054 GRENOBLE CEDEX 09 (FR); NAUDIN, Florence, 38054 GRENOBLE CEDEX 09 (FR); VANDENBOSSCHE, Martin, 38054 GRENOBLE CEDEX 09 (FR)
(74) Mandataire: Santarelli

(57) **Abrégé**

L'invention porte sur un procédé de polissage chimique pour obtenir un lot de plaques lissées. Il comporte une fourniture de plusieurs plaques de silicium comprenant chacune une face de découpe, une mesure d'une réflectivité diffuse de la face de découpe de chaque plaque de silicium, une sélection d'un ensemble de plaques parmi les plaques fournies ayant leur réflectivité diffuse inférieure ou égale à un seuil de réflectivité prédéterminé, et une gravure humide anisotrope de l'ensemble de plaques selon des plans cristallins du silicium pour obtenir le lot de plaques lissées. Le seuil de réflectivité prédéterminé garantit un dépôt conforme d'une couche mince sur la face de découpe de chaque plaque du lot de plaques lissées.

## Description

### DOMAINE TECHNIQUE

Le domaine de l'invention est celui des procédés de lissage ou de polissage des plaques de silicium, notamment pour la fabrication de cellules photovoltaïques.

### ÉTAT DE LA TECHNIQUE ANTÉRIEURE

Les plaques de silicium, notamment pour la fabrication de cellules photovoltaïques, sont obtenues par découpe d'un lingot de silicium. Les techniques de découpe les plus répandues mettent en œuvre un sciage du lingot de silicium par des fils. Elles permettent notamment de découper un grand nombre de plaques simultanément. Parmi celles-ci, une méthode particulièrement avantageuse consiste à utiliser des fils enduits de diamant synthétiques, appelés fils diamantés. Il s'agit d'une méthode rapide, permettant de minimiser la production de déchets de silicium.

Pour minimiser des coûts économiques et environnementaux de la production de cellules photovoltaïques, il est nécessaire de diminuer la quantité de déchets de silicium produite lors de la production de plaques, et d'augmenter le nombre de plaques produites par lingot de silicium. Ce dernier objectif peut être atteint en diminuant l'épaisseur des plaques produites après sciage, ce qui peut les fragiliser. A titre d'exemple, les épaisseurs de plaques de silicium pour des applications photovoltaïques sont généralement comprises entre 150 µm et 200 µm.

L'étape de découpe génère généralement une zone écrouie s'étendant sur une faible profondeur depuis chaque face de la plaque engendrée par la découpe, appelée face de découpe. Une zone écrouie est une zone rugueuse de la plaque, déformée plastiquement. Elle comporte des microfissures et/ou des défauts cristallins, comme des dislocations. Elle peut être contaminée par des atomes de métal. Il convient par conséquent de la supprimer pour la fabrication de certains composants électroniques dans et/ou sur la plaque, comme par exemple certaines cellules photovoltaïques.

Il est connu de retirer une zone écrouie par un polissage mécano-chimique. Cependant ce précédé est souvent coûteux, notamment pour la fabrication de cellules photovoltaïques. Il est par conséquent souvent préféré une gravure chimique anisotrope de la zone écrouie par une solution de gravure. Un tel procédé est couramment appelé polissage chimique dans l'industrie des cellules photovoltaïques. La solution de gravure est généralement du KOH.

Le retrait de la zone écrouie a pour conséquence de diminuer l'épaisseur de la plaque de silicium, déjà significativement réduite lors de l'étape de découpe pour les raisons expliquées supra. Il convient donc de parvenir à retirer la zone écrouie de façon à la supprimer, sans trop diminuer l'épaisseur de la plaque de silicium en-deçà d'une limite pour laquelle elle risquerait de se briser lors d'étapes de procédé ultérieures, comme une étape de manipulation de plaques, ou de recuit thermique.

Lorsque la zone écrouie est retirée par un polissage chimique, il se forme des motifs sur la face de découpe correspondant à des pyramides à base carrée. Les pyramides tronquées, appelées mésas, sont majoritaires. La forme et la densité des motifs dépendent de conditions de la gravure chimique, comme par exemple, la concentration en KOH de la solution, la température de la solution ou le temps d'immersion de la plaque dans la solution. L'ensemble des motifs, généralement de tailles supérieures à 1 micron, génère une rugosité de la face de découpe pouvant être responsable d'une rupture d'une couche mince déposée par voie liquide sur celle-ci, notamment lorsqu'un ou plusieurs motifs ont des hauteurs supérieures à l'épaisseur de la couche mince.

### EXPOSÉ DE L'INVENTION

L'invention a pour objectif de remédier au moins en partie aux inconvénients de l'art antérieur, et plus particulièrement de proposer un procédé de polissage chimique pour obtenir un lot de plaques de silicium garantissant un dépôt par voie liquide d'une couche mince conforme sur une face de découpe de chaque plaque du lot.

Pour cela, l'objet de l'invention est un procédé de polissage chimique pour obtenir un lot de plaques lissées. Le procédé comporte les étapes suivantes : fourniture de plusieurs plaques de silicium comprenant chacune une face de découpe ; mesure d'une réflectivité diffuse de la face de découpe de chaque plaque de silicium ; sélection d'un ensemble de plaques parmi les plaques fournies ayant leur réflectivité diffuse inférieure ou égale à un seuil de réflectivité prédéterminé ; gravure humide anisotrope de l'ensemble de plaques selon des plans cristallins du silicium pour obtenir le lot de plaques lissées.

Le procédé de polissage chimique est tel que le seuil de réflectivité prédéterminé garantit un dépôt conforme d'une couche mince sur la face de découpe de chaque plaque du lot de plaques lissées.

Certains aspects préférés mais non limitatifs de ce procédé de polissage chimique sont les suivants.

La gravure anisotrope peut être une gravure par une solution pouvant contenir une concentration massique de KOH supérieure ou égale à 20 %. La solution peut être à une température supérieure ou égale à 70 °C.

Chaque plaque de silicium fournie peut comprendre une zone écrouie pouvant s'étendre en profondeur depuis la face de découpe. La gravure anisotrope peut retirer la zone écrouie de toutes les plaques de l'ensemble.

L'étape de gravure anisotrope peut conduire à un amincissement de chaque plaque de l'ensemble. L'amincissement peut être inférieur ou égal à 60 µm.

L'invention porte également sur un procédé de fabrication d'un ensemble de cellules photovoltaïques à base de silicium, comprenant l'obtention d'un lot de plaques lissées par un procédé de polissage chimique selon l'une quelconque des caractéristiques précédentes. La couche mince peut être une couche fonctionnelle d'une ou plusieurs cellules photovoltaïques de l'ensemble. Le procédé de fabrication peut comprendre un dépôt conforme par voie liquide ou par évaporation sur la face de découpe de chaque plaque du lot de la couche fonctionnelle.

La face de découpe peut être nanostructurée entre l'étape de gravure anisotrope et l'étape de dépôt.

Des premières cellules de l'ensemble de cellules photovoltaïques peuvent être des cellules tandem silicium-pérovskite. La couche fonctionnelle peut être une couche de pérovskite ou une couche de contact pour fabriquer les premières cellules.

Des deuxièmes cellules de l'ensemble de cellules photovoltaïques peuvent être des cellules photovoltaïques à simple jonction à base de silicium.

Le procédé de fabrication peut comprendre en outre une étape d'obtention d'un lot subsidiaire de plaques comprenant des plaques de l'ensemble de plaques ayant leur réflectivité diffuse strictement supérieure au seuil de réflectivité prédéterminé lors de l'étape de sélection du procédé de polissage chimique,

Le procédé de fabrication peut comprendre une fabrication des deuxièmes cellules dans et/ou sur les plaques du lot subsidiaire.

La couche fonctionnelle peut avoir une épaisseur inférieure ou égale à 1 µm.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
la figure 1 illustre une méthode de mesure de la réflectivité diffuse d'une face pouvant être utilisée pour une étape de sélection d'un exemple de procédé selon l'invention ;
la figure 2A montre des résultats de mesure de la réflectivité diffuse de faces de découpe en fonction d'une durée de gravure dans une première solution de gravure ;
la figure 2B montre des résultats de mesure de la réflectivité diffuse de faces de découpe en fonction d'une durée de gravure dans une deuxième solution de gravure ;
la figure 3 montre les résultats de mesure des figures 2A et 2B, en fonction de vitesses de gravure moyennes constatées ;
la figure 4 est une image au microscope optique d'une face de découpe traitée par un exemple d'un procédé de polissage chimique selon l'invention.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

L'invention porte sur un procédé de polissage chimique de plaques de silicium découpées dans un lingot de silicium, ne mettant pas en œuvre un polissage mécano-chimique. Chaque plaque de silicium correspond à une tranche du lingot de silicium, désolidarisée de celui-ci par une étape de découpe, par exemple à l'aide d'un fil diamanté. Elle comporte une face de découpe au niveau d'une surface qui la maintenait solidairement au lingot de silicium.

Le procédé de polissage chimique comprend une étape de gravure humide anisotrope de la face de découpe, par exemple dans une solution d'hydroxyde de potassium (KOH). Les inventeurs ont constaté qu'une mesure d'une réflectivité diffuse de la face de découpe après découpe, c'est-à-dire sur des plaques de silicium obtenues après découpe (plaques communément appelées « as cut », selon l'utilisation d'un anglicisme), est prédictive d'une rugosité de la face de découpe après l'étape de gravure. Aussi, le procédé de polissage chimique comprend la sélection d'un ensemble de plaques de silicium telles que leurs réflectivités diffuses respectives sont inférieures ou égales à un seuil de réflectivité diffuse prédéterminé garantissant un lissage de la face de découpe par la gravure. Le seuil de réflectivité peut être prédéterminé de façon à garantir qu'une rugosité de la face de découpe soit inférieure ou égal à une spécification. La spécification peut être une rugosité maximale vallée à crête permettant un dépôt conforme par voie liquide d'une couche mince sur la face de découpe après l'étape de gravure.

Le terme de « dépôt par voie liquide » regroupe différentes méthodes de dépôt d'une couche d'un matériau sous forme liquide. Le liquide peut par exemple comprendre le matériau et un solvant. A titre d'exemples, le dépôt peut se faire par centrifugation du liquide (ou « spin-coating », en anglais), par immersion dans un bain contenant le liquide, ou par enduction par pulvérisation. Dans une méthode de dépôt par centrifugation, le liquide peut être distribué par une buse et/ou un spray.

Dans la description et dans le domaine technique des cellules photovoltaïques, un dépôt conforme ou un dépôt de manière conforme d'une couche sur une face est tel que la couche s'étend continument sur la face, sans zone de rupture de la couche. Dans ce cas, la face est entièrement recouverte par la couche. La couche résultant d'un tel dépôt est une couche conforme. Il est délicat d'obtenir un dépôt conforme d'une couche mince sur une face rugueuse ou structurée, que ce soit par voie liquide ou par évaporation, en raison d'une mauvaise uniformité de mouillage dans le premier cas, et d'une forte directivité de dépôt dans le second. La conformité d'un dépôt peut être vérifiée sur un dispositif complet intégrant la couche déposée, notamment par la constatation de l'absence de court-circuit, celle-ci pouvant être effectuée par imagerie par électroluminescence.

La rugosité d'une surface est une mesure quantitative des variations de hauteurs de la surface par rapport à une surface de référence. Dans le contexte de l'invention, la surface de référence est de préférence une surface plane. La mesure quantitative peut être égale à la moyenne quadratique des hauteurs dans une gamme de fréquences spatiales, ou encore à la moyenne de la valeur absolue des hauteurs dans la gamme de fréquences spatiales. Elle peut être aussi égale à la hauteur maximale en valeur absolue ou à une différence maximale vallée à crête de la hauteur sur une distance donnée. Elle peut être mesurée à l'aide d'un microscope à force atomique ou un profilomètre.

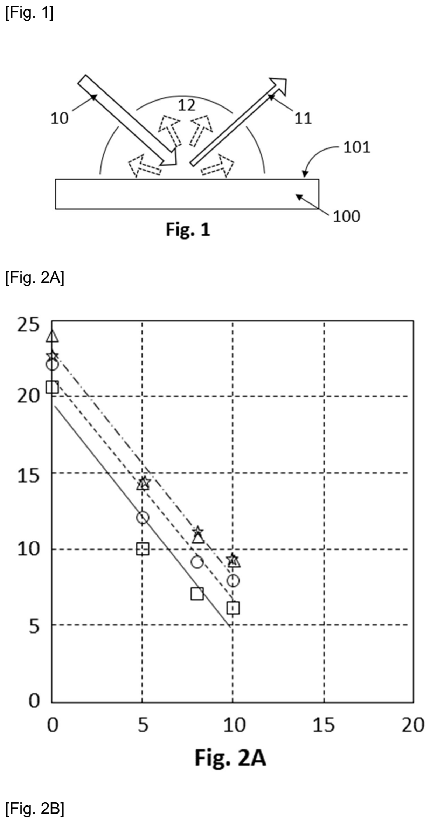

La figure 1 illustre une méthode de mesure de la réflectivité diffuse d'une face pouvant être utilisée lors d'une étape de sélection d'un exemple de procédé de polissage chimique selon l'invention. La méthode de mesure peut être mise en œuvre dans un spectrophotomètre.

Un faisceau incident 10 illumine une plaque 100 sur une face supérieure de la plaque 100. Le faisceau incident 10 fait un angle d'incidence θᵢ non nul avec une normale à la face supérieure. La face supérieure peut être quelconque. Il s'agit ici d'une face de découpe 101 d'une plaque en silicium, par exemple une plaque pour des applications dans le domaine du photovoltaïque. La plaque de silicium peut par exemple avoir une orientation cristalline (100). La plaque 100 est de préférence éclairée en lumière rasante par le faisceau incident 10.

Le faisceau incident 10 est réfléchi en partie par réflexion spéculaire en un faisceau réfléchi 11 se propageant selon une direction spéculaire de l'espace faisant un angle θ_{S} avec la normale à la face de découpe 101, égal à θᵢ en valeur absolue. La réflectivité spéculaire R_{S} est égale au rapport de l'intensité du faisceau réfléchi 11 sur l'intensité du faisceau incident 10.

Le faisceau incident 10 est également en partie diffusé en une lumière diffusée 12, par une rugosité de la face de découpe 101, dans des directions de l'espace différentes de la direction spéculaire. La réflectivité diffuse R_{D} est égale au rapport de l'intensité de la lumière diffusée 12 sur l'intensité du faisceau incident 10.

Les intensités respectives du faisceau incident 10, du faisceau réfléchi 11 et de la lumière diffusée 12 peuvent être mesurées par un ou plusieurs détecteurs photoélectriques. La réflectivité diffuse est une fonction strictement croissante de la rugosité la face de découpe 101. Il est par exemple possible d'établir empiriquement une loi de correspondance ou un abaque donnant la rugosité de la face de découpe 101 en fonction de sa réflectivité diffuse. Cette loi ou cet abaque est susceptible de varier d'un spectrophotomètre à un autre ou d'un banc d'expérience à un autre. Ils dépendent également d'autres paramètres, parmi ceux-ci, on peut citer la longueur d'onde ou la gamme de longueurs d'onde du faisceau incident 10, l'angle d'incidence θᵢ, ou encore une dimension du faisceau incident 10 au niveau de la face de découpe 101.

Un exemple de procédé de polissage chimique selon l'invention va à présent être décrit.

Lors d'une première étape, on fournit des plaques 100 en silicium, par exemple destinées à des applications dans le domaine des cellules photovoltaïques. Les plaques 100 peuvent par exemple avoir toutes, la même orientation cristalline. Dans cet exemple, ce sont toutes des plaques en silicium orientées selon un plan cristallin (100). Les plaques peuvent par exemple être fournies par un fabricant de plaques. Elles peuvent être dopées de type n ou p.

Les plaques 100 en silicium correspondent à des tranches ou des parties de tranches d'un ou plusieurs lingots de silicium, par exemple obtenus par un procédé de croissance de type Czochralski (CZ). Elles peuvent être de toute forme. Elles sont par exemple toutes en forme de disque ou de parallélépipède ou de prisme droit. Elles peuvent avoir des épaisseurs standards, par exemple comprises entre 160 µm et 180 µm. Elles ont été obtenues par découpe du ou des lingots de silicium, par exemple à l'aide d'un ou plusieurs fils diamantés. Chacune comprend par conséquent une face de découpe 101 au niveau d'un plan de coupe du lingot dont elle est issue. Lorsque la plaque 100 a été désolidarisée du lingot par un fil diamanté, la face de découpe 101 est une surface de la plaque 100 qui a été en contact avec le fil diamanté lors de la découpe.

Chaque plaque 100 en silicium comporte généralement une zone écrouie s'étendant en profondeur depuis la face de découpe 101, notamment lorsque la plaque 100 a été découpée à l'aide d'un fil en présence d'un abrasif, ou un fil diamanté. Comme rappelé dans la partie « état de la technique », une zone écrouie comporte généralement des microfissures et/ou des défauts cristallins. Lorsque la plaque « as cut » a été découpée par un fil diamanté, elle comporte généralement des stries de profondeurs variables. Elle peut être contaminée par des atomes de métal. Elle peut s'étendre sur une profondeur comprise entre 5 µm et 12 µm, généralement de l'ordre de 8 µm. Une zone écrouie peut causer un certain nombre de dysfonctionnements de composants électriques ou électroniques réalisés dans et/ou sur les plaques, comme par exemple une augmentation d'un taux de recombinaison de porteurs, des difficultés pour collecter des charges électriques, une altération de profils de dopage, ou un vieillissement prématuré des composants. La zone écrouie a généralement une rugosité susceptible de compromettre l'enduction d'une couche conforme par voie liquide.

Lors d'une deuxième étape, on mesure la réflectivité diffuse de la face de découpe 101 de chaque plaque 100 en silicium par la méthode de mesure illustrée en figure 1. La réflectivité diffuse peut être égale à la moyenne des réflectivités diffuses obtenues dans une gamme de longueurs d'onde et/ou à différentes positions de la face de découpe 101. De préférence, la face de découpe n'a pas subi d'opérations affectant l'amplitude ou la nature de sa rugosité entre la découpe et l'étape de mesure. Une ou plusieurs étapes de nettoyage peut être prévues entre la découpe et l'étape de mesure.

Dans cet exemple, on mesure la réflectivité diffuse moyenne dans une gamme de longueurs d'onde, par exemple comprises entre 300 nm et 1200 nm, ou entre 350 nm et 1000 nm, ici mesurée au centre de la face de découpe 101. Le faisceau incident a par exemple une taille de 15 mm par 7 mm, au niveau de la face de découpe 101. L'angle d'incidence θᵢ peut être égal à 82 degrés.

Lors d'une troisième étape, on sélectionne ou on trie un ensemble de plaques parmi les plaques mesurées lors de la deuxième étape. Les plaques de l'ensemble de plaques ont chacune, leur réflectivité diffuse inférieure ou égale à un seuil de réflectivité prédéterminé.

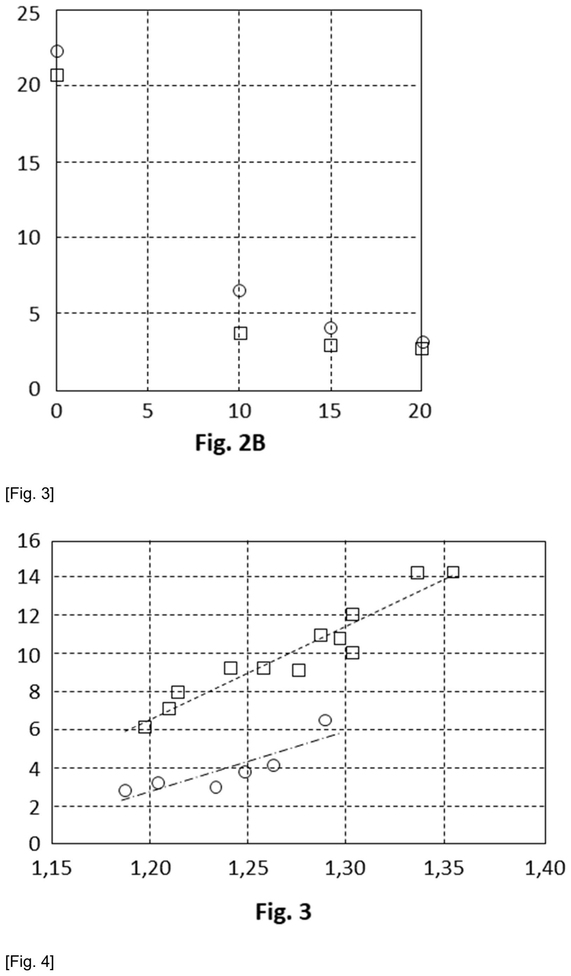

Les figures 2A et 2B illustrent des résultats expérimentaux pouvant servir à établir le seuil de réflectivité prédéterminé.

En figure 2A, on a reporté sur un graphique la réflectivité diffuse moyenne (axe des ordonnées, en pourcentage) mesurée après différentes durées d'immersion dans une solution d'hydroxyde de potassium (KOH) (axe des abscisses, en minutes), pour différentes plaques (chaque symbole correspond à un fournisseur de plaques différent, chaque point correspond à une plaque différente). La concentration massique de KOH dans la solution, ici aqueuse, est égale à 35 %. La température d'immersion est égale à 80 °C. La réflectivité diffuse moyenne est égale ici à la moyenne des réflectivités diffuses mesurées sur la face de découpe de chaque plaque, pour des longueurs d'onde du faisceau incident 10 comprises entre 350 nm et 1 µm. Chaque point obtenu pour un fournisseur particulier et une durée d'immersion nulle, correspond à la réflectivité diffuse moyenne mesurée sur la face de découpe 101 de chaque plaque « as cut » de ce fournisseur, utilisée dans cette expérience. Il a notamment été constaté, lors de cette expérience, que la variabilité plaque à plaque de la réflectivité diffuse moyenne des plaques « as cut » issues d'un fournisseur est très inférieure à la variabilité de la réflectivité diffuse entre deux plaques « as cut » issues de deux fournisseurs différents.

Les droites représentent les régressions linéaires selon la méthode des moindres carrés obtenues à partir des données expérimentales. Les régressions linéaires des plaques symbolisées par des carrés, des cercles et des triangles sont respectivement représentées par une ligne en trait plein, une ligne en pointillés et une ligne mixte. Par soucis de clarté, la régression linéaire de la plaque symbolisée par des étoiles n'a pas été représentée car elle est très proche de celle de la plaque symbolisée par des triangles.

Il est constaté que la réflectivité diffuse moyenne diminue lorsque la durée d'immersion augmente, ce qui fait que l'immersion dans la solution de KOH a pour effet de lisser la face de découpe. La diminution de la réflectivité diffuse moyenne, et donc de la rugosité, est sensiblement linéaire pour tous les fournisseurs de plaques. La diminution de la réflectivité diffuse moyenne en fonction de la durée d'immersion est sensiblement la même pour tous les fournisseurs de plaques et, par voie de conséquence, des différences de rugosité entre plaques sont sensiblement conservées, quelle que soit la durée d'immersion. Ainsi, une mesure d'une réflectivité diffuse d'une face de découpe avant immersion (abscisse nulle) est prédictive de la réflectivité diffuse de cette face de découpe après immersion, et donc de la rugosité de la face de découpe, quel que soit la durée d'immersion.

En figure 2B, on a reporté sur un graphique des résultats expérimentaux similaires à ceux de la figure 2A. La concentration massique de KOH dans la solution est ici égale à 30 %. La température d'immersion est aussi égale à 80 °C. L'axe des ordonnées donne la réflectivité diffuse moyenne en %, égale à la moyenne des réflectivités diffuses mesurées pour des longueurs d'onde comprises entre 350 nm et 1 µm. L'axe des abscisses donne la durée d'immersion en minutes. Les mesures de plaques provenant de deux fournisseurs de plaques différents sont respectivement repérées par des carrés et des cercles.

Similairement à l'expérience de la figure 2A, il a été constaté ici que la variabilité plaque à plaque de la réflectivité diffuse moyenne des plaques « as cut » issues d'un fournisseur est très inférieure à la variabilité de la réflectivité diffuse entre deux plaques « as cut » provenant des deux fournisseurs de plaques.

Tout comme en figure 2A, il est constaté que la diminution de la réflectivité diffuse moyenne en fonction de la durée d'immersion est sensiblement la même pour les deux fournisseurs de plaques, jusqu'à une durée d'immersion de 15 minutes. Il est également constaté qu'en deçà d'une réflectivité diffuse d'environ 5%, la réflectivité diffuse décroit moins vite lorsque la durée d'immersion augmente, ce qui a pour effet de réduire l'écart entre les réflectivités diffuses des deux fournisseurs de plaques à 20 minutes d'immersion, tout en restant du même signe. Pour réduire les coûts de production, il est préférable de diminuer la durée d'immersion dans la solution.

A titre de comparaison, la réflectivité diffuse moyenne d'une face de découpe polie par un polissage mécano-chimique (CMP) est typiquement égale à 1 % dans la gamme de longueurs d'onde comprises entre 300 nm et 1,2 µm.

Au cours des expériences des figures 2A et 2B, on a pesé chacune des plaques, après chaque durée d'immersion et avant de les immerger dans les solutions. On a ensuite calculé une cinétique de gravure moyenne pour chaque durée d'immersion en divisant la différence des poids avant immersion et après immersion, par la masse volumique du silicium multipliée par la ou les surfaces exposées à la solution. Les résultats de ce calcul ont été reportés sur le graphique de la figure 3. En abscisse, il est donné la valeur de la cinétique de gravure moyenne en µm par minute. En ordonnée, il est donné les réflectivités diffuses des figures 2A et 2B, en pourcentage. Les carrés et les cercles correspondent respectivement, aux mesures des plaques de la figure 2A et de la figure 2B.

Les valeurs numériques correspondant aux points expérimentaux des figures 2A et 3 sont communiquées dans le Tableau 1 ci-dessous.

**Tableau 1**

| Durée (minutes) | Fournisseur | Cinétique de gravure (µm/min) | R_{D} (%) |
|---|---|---|---|
| 5 | Cercle | 1,30 | 12,08 |
| | Triangle | 1,34 | 14,22 |
| | Carré | 1,30 | 10,04 |
| | Etoile | 1,35 | 14,37 |
| 8 | Cercle | 1,28 | 9,11 |
| | Triangle | 1,30 | 10,80 |
| | Carré | 1,21 | 7,09 |
| | Etoile | 1,29 | 11,09 |
| 10 | Cercle | 1,21 | 7,99 |
| | Triangle | 1,24 | 9,21 |
| | Carré | 1,20 | 6,17 |
| | Etoile | 1,26 | 9,23 |

Les valeurs numériques correspondant aux points expérimentaux des figures 2B et 3 sont communiquées dans le Tableau 2 ci-dessous.

**Tableau 2**

| Durée (minutes) | Fournisseur | Cinétique de gravure (µm/min) | R_{D} (%) |
|---|---|---|---|
| 10 | Cercle | 1,29 | 6,54 |
| | Carré | 1,25 | 3,79 |
| 15 | Cercle | 1,26 | 4,14 |
| | Carré | 1,23 | 2,97 |
| 20 | Cercle | 1,20 | 3,2 |
| | Carré | 1,19 | 2,76 |

Pour la mise en œuvre de la troisième étape, le seuil peut par exemple être prédéterminé de façon à garantir que les rugosités des faces de découpe de l'ensemble de plaques restent inférieures à une spécification, après une immersion dans une solution de KOH d'une durée inférieure à une durée maximale au-delà de laquelle les plaques de l'ensemble seraient trop fines et risqueraient de se briser, ou au-delà de laquelle le procédé de polissage chimique serait trop onéreux. Pour des applications dans le domaine des cellules photovoltaïques, il est considéré que l'épaisseur des plaques doivent rester supérieure à 60 µm, voire 90 µm, pour ne pas risquer de se briser. Ainsi, une variation d'épaisseur de la plaque au cours de l'immersion dans la solution, inférieure ou égale à 60 µm est souhaitable, préférentiellement inférieure ou égale à 50 µm. Lorsque les plaques de l'ensemble comprennent chacune une zone écrouie, la variation d'épaisseur est avantageusement suffisante pour retirer toute la zone écrouie de toutes les plaques.

La spécification peut correspondre à un niveau de rugosité maximale de la face de découpe en deçà de laquelle il est possible de déposer une couche mince d'épaisseur donnée par un dépôt conforme par voie liquide ou par évaporation. Le cas échéant, la spécification est généralement une rugosité mesurée crête à vallée, inférieure ou égale à l'épaisseur de la couche mince. La spécification peut intégrer une rugosité additionnelle apportée par une étape optionnelle de nano-structuration mise en œuvre entre l'immersion et le dépôt de la couche mince. La couche mince peut par exemple avoir une épaisseur inférieure ou égale à 1 µm.

Lors d'une quatrième étape de l'exemple de procédé de polissage chimique selon l'invention, on grave la face de découpe 101 par une gravure humide anisotrope selon des plans cristallins du silicium, c'est-à-dire que la face de découpe 101 est mise en contact avec une solution de gravure gravant plus rapidement certains plans cristallins du silicium, par rapport à d'autres. Une solution d'hydroxyde de tétraméthylammonium (TMAH) ou une solution d'hydroxyde de potassium (KOH) peuvent par exemple être utilisées à cet effet. La solution peut être mise en contact de la face de découpe 101 par tout moyen connu de la personne du métier.

Préférentiellement, chaque plaque de l'ensemble est immergée dans un bain contenant la solution de gravure. Avantageusement, plusieurs plaques sont immergées simultanément. Le bain peut être maintenu à une température sensiblement constante, par exemple à 70 °C ou 80 °C. De préférence, comme c'est le cas dans cet exemple de procédé, la solution de gravure est une solution d'hydroxyde de potassium concentrée, ceci afin de réduire des coûts de fabrication. La concentration massique de KOH dans la solution peut par exemple être supérieure ou égale à 20 %, 30 % ou 35 %.

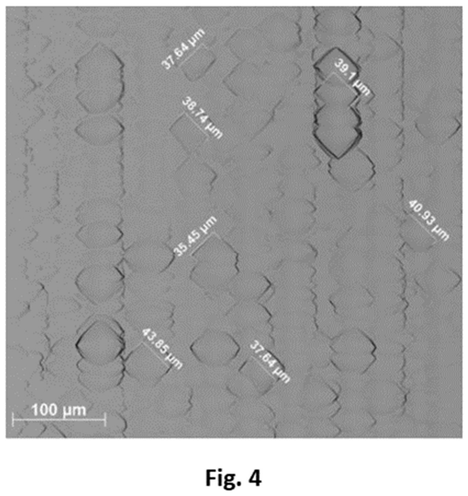

La quatrième étape permet de diminuer la rugosité des faces de découpe 101 et d'obtenir ainsi un lot de plaques lissées. La figure 4 montre une image au microscope optique d'un exemple de face de découpe obtenue à l'issue de la quatrième étape, après une immersion de 8 minutes. La rugosité est dominée par des structures cristallines en forme de mesa, ici de dimensions horizontales de l'ordre de 38 µm. Il a été constaté que la largeur des mesas augmente de façon sensiblement proportionnelle avec la durée de l'immersion.

Le lot de plaques lissées peut servir à la fabrication de cellules photovoltaïques à base de silicium, de tout type. Il est notamment particulièrement avantageux pour réduire le coût de fabrication de cellules photovoltaïques de type tandem silicium-pérovskite, notamment du fait de l'absence de polissage mécano-chimique.

Dans le cadre de la fabrication de cellules photovoltaïques, il est souvent déposé une couche par voie liquide ou par évaporation sur la face de découpe 101. Cette couche peut être une couche fonctionnelle, c'est-à-dire qu'elle joue un rôle pour le fonctionnement de la cellule photovoltaïque. Il peut s'agir par exemple d'une couche participant à la collecte de charges électriques.

Dans le cas de la fabrication de cellules tandem silicium-pérovskite, la couche peut être une couche de pérovskite ou une couche de contact. De préférence, on forme des nanostructures sur une région de la face de découpe 101 destinée à recevoir la couche et un flux lumineux devant être absorbé par la cellule tandem. Les nanostructures peuvent être formées après la gravure humide anisotrope.

Les tailles des nanostructures et leurs distances de séparation deux à deux sont adaptées pour améliorer un rendement d'absorption du flux lumineux par la cellule tandem. Lorsque la face de découpe 101 comporte des mesas à l'issue de la gravure anisotrope, celles-ci sont généralement trop grandes par rapport aux longueurs d'onde du flux lumineux pour atteindre cet objectif, notamment lorsque le flux lumineux est le flux solaire. A titre d'exemple, les nanostructures peuvent avoir une hauteur inférieure ou égal à 1 µm. Elles peuvent chacune avoir une base de dimensions horizontales comprises entre 600 nm et 800 nm. Elles peuvent être obtenues par gravure dans une solution comprenant de l'hydroxyde de potassium (KOH) dilué et un ou plusieurs surfactants.

Ainsi, il est possible de retirer à moindre coût, une zone écrouie créée par la découpe de la plaque, et d'obtenir une face de découpe 101 de rugosité contrôlée permettant à la fois d'augmenter l'efficacité de conversion, ou rendement, de la cellule tandem et de déposer par voie liquide de façon conforme des couches constitutives de la cellule tandem.

Les plaques non sélectionnées lors de la troisième étape peuvent avantageusement être retenues pour des cellules photovoltaïques standards à base de silicium, ne nécessitant pas un contrôle précis de la rugosité de la face de découpe 101. Les photovoltaïques standards peuvent être des cellules photovoltaïques à simple jonction, par exemple des cellules à hétérojonction ou des cellules de type PERC (pour « Passivated Emitter and Rear Cell », en anglais) ou Topcon (pour « Tunnel Oxide Passivated Contact », en anglais).

Des modes de réalisation particuliers viennent d'être décrits. Différentes variantes et modifications apparaîtront à l'homme du métier. Il est par exemple possible d'omettre la troisième étape de sélection et d'ajuster la durée d'immersion lors de la quatrième étape de gravure anisotrope sur la base des mesures de réflectivité diffuse obtenues à la deuxième étape, ceci afin d'obtenir le lot de plaques lissées. Dans ce cas, la durée d'immersion est d'autant plus grande que la réflectivité diffuse est importante. Les durées d'immersion utilisées pour deux plaques peuvent être différentes pour obtenir des rugosités des faces de découpes respectives satisfaisant à une spécification.

## Revendications

1. Procédé de polissage chimique pour obtenir un lot de plaques lissées, le procédé comportant les étapes suivantes :
∘ fourniture de plusieurs plaques de silicium comprenant chacune une face de découpe,
∘ mesure d'une réflectivité diffuse de la face de découpe de chaque plaque de silicium,
∘ sélection d'un ensemble de plaques parmi les plaques fournies ayant leur réflectivité diffuse inférieure ou égale à un seuil de réflectivité prédéterminé,
∘ gravure humide anisotrope de l'ensemble de plaques selon des plans cristallins du silicium pour obtenir le lot de plaques lissées,
le procédé de polissage chimique étant tel que le seuil de réflectivité prédéterminé garantit un dépôt conforme d'une couche mince sur la face de découpe de chaque plaque du lot de plaques lissées.

2. Procédé de polissage chimique selon la revendication 1, dans lequel la gravure anisotrope est une gravure par une solution contenant une concentration massique de KOH supérieure ou égale à 20 %, à une température supérieure ou égale à 70 °C.

3. Procédé de polissage chimique selon les revendications 1 ou 2, dans lequel chaque plaque de silicium fournie comprend une zone écrouie s'étendant en profondeur depuis la face de découpe, et la gravure anisotrope retire la zone écrouie de toutes les plaques de l'ensemble.

4. Procédé de polissage chimique selon l'une quelconque des revendications 1 à 3, dans lequel l'étape de gravure anisotrope conduit à un amincissement de chaque plaque de l'ensemble, inférieur ou égal à 60 µm.

5. Procédé de fabrication d'un ensemble de cellules photovoltaïques à base de silicium, comprenant les étapes suivantes :
∘ obtention d'un lot de plaques lissées par un procédé de polissage chimique selon l'une quelconque des revendications 1 à 4, dans lequel la couche mince est une couche fonctionnelle d'une ou plusieurs cellules photovoltaïques de l'ensemble,
∘ dépôt conforme par voie liquide ou par évaporation sur la face de découpe de chaque plaque du lot de la couche fonctionnelle.

6. Procédé de fabrication selon la revendication 5, dans lequel la face de découpe est nanostructurée entre l'étape de gravure anisotrope et l'étape de dépôt.

7. Procédé de fabrication selon les revendications 5 ou 6, dans lequel des premières cellules de l'ensemble de cellules photovoltaïques sont des cellules tandem silicium-pérovskite, et dans lequel la couche fonctionnelle est une couche de pérovskite ou une couche de contact pour fabriquer les premières cellules.

8. Procédé de fabrication selon la revendication 7, dans lequel des deuxièmes cellules de l'ensemble de cellules photovoltaïques sont des cellules photovoltaïques à simple jonction à base de silicium et dans lequel le procédé de fabrication comprend en outre :
∘ une étape d'obtention d'un lot subsidiaire de plaques comprenant des plaques de l'ensemble de plaques ayant leur réflectivité diffuse strictement supérieure au seuil de réflectivité prédéterminé lors de l'étape de sélection du procédé de polissage chimique,
∘ une fabrication des deuxièmes cellules dans et/ou sur les plaques du lot subsidiaire.

9. Procédé de fabrication selon l'une quelconque des revendications 5 à 8, dans lequel la couche fonctionnelle a une épaisseur inférieure ou égale à 1 µm.
